# EUROPEAN PATENT SPECIFICATION

(11) **EP 0 359 518 B1**
(45) Date of publication and mention of the grant of the patent: **10.02.1993**
(21) Application number: 89309238.7
(22) Date of filing: 12.09.1989
(51) Int. Cl.: C04B 41/51, C04B 41/53, H01L 23/14

(54) **Improvements in aluminium nitride substrates**
Aluminiumnitrid-Substrate
Substrates de nitrure d'aluminium

(30) Priority: 13.09.1988 JP 229400/88
(43) Date of publication of application: 21.03.1990
(73) Proprietor: KABUSHIKI KAISHA TOSHIBA, Kawasaki-shi, Kanagawa-ken 210 (JP)
(72) Inventor: Sato, Hideki c/o Intellectual Property Division, Tokyo (JP); Sugiura, Yasuyuki Intellectual Property Division, Tokyo (JP)
(74) Representative: BATCHELLOR, KIRK & CO.

(56) References cited:
- EP-A- 0 153 737
- EP-A- 0 227 371
- US-A- 4 681 656
- SPRECHSAAL. vol. 118, no. 3, March 1985, COBURG DE pages 245 - 249; M. Billy et al.: "Processing and Properties of Aluminium Nitride, a New Candidate for High Temperature Applications."

## Description

This invention is concerned with aluminium nitride substrates and methods for making or modifying them.

Industrial use of ceramics has increased in recent years, and electronic components have utilised ceramics in an increasing scale. Semiconductor substrates have become an important application for ceramics. In fact, notwithstanding its recent development to practical implementation, the technology of using aluminium nitride ceramics as semiconductor element substrates is the subject of considerable research.

One area of such research is the development of methods of producing many products simultaneously. A mass-production method for aluminium nitride ceramics has been considered. There are many uses for such substrates. For purposes of illustration, however, a semiconductor substrate of dimension 10 mm x 10 mm x 0.7 mm will be discussed.

A method of producing semiconductor substrates includes several steps of preparing a ceramic substrate, metallising onto the substrate, electroless-plating onto the metallised portion, mounting a silicon semiconductor chip thereon, electrically connecting the chip with the electroless-plated portion through bonding wires, covering the substrate with resin, and installation into a product of transistor modules. Observations suggest it is not advantageous to treat substrates one by one according to these steps, because the substrates are too small. Separate processing results in a ratio of good products to total products which deteriorates with decreasing substrate size.

A method has been developed for using a large ceramic substrate. Several steps are used for preparing a large ceramic substrate, metallising many patterns onto the substrate, electroless-plating onto the metallised portions, sub-dividing the substrate into prescribed dimensions, mounting silicon semiconductor chips thereon, respectively, electrically connecting each chip with the electroless-plated portion through bonding wires, covering the substrate with resin, and installation into products of transistor modules. In this case, we have used a high density energy means for sub-dividing the substrate into prescribed dimensions. High density energy means include, for example, laser means and electron beam means. We prefer use of a laser as a high density energy means because its equipment is simpler and cheaper than that of electron beam means. This method of using a laser has two steps, namely, making holes or bores or a series of consecutive holes or bores, or making one or more grooves (hereinafter, these are all ways of making score lines) on the substrate by directing the laser at prescribed portions on the substrate, and severing the substrate along these score lines after the step of electroless-plating.

When score lines are formed in this way on an aluminium nitride substrate surface by high density energy working, the phenomenon of segregation of metallic aluminium in the vicinity of this worked surface has been found to occur. It is therefore found that, in the nickel plating stage, in which the substrate is covered with a metallising layer constituting the electrically conductive layer necessary for an electronic component, the plating layer also covers the metallic layer that is present in the worked surface. This impairs the withstand-voltage characteristic that is required for electronic component substrates.

We have developed several methods of removing this metallic aluminium. They employ mechanical means in a honing step, using abrasive and the like, or placing the substrate in water and irradiating with a laser. However, in the former method, it is difficult to verify whether or not removal is completely In the latter method, a complicated system is required.

It is therefore an object of the present invention to mitigate disadvantages associated with existing practices for producing or modifying aluminium nitride substrates.

The present invention seeks to provide an aluminium nitride substrate having attractive withstand-voltage characteristics and semiconductor devices having a semiconductor circuit mounted on an improved substrate according to the invention.

According to one aspect of the present invention there is provided an aluminium nitride substrate having a high density energy means-generated score line in at least one portion thereof, the substrate having a re-solidified layer in the vicinity of the score line comprised of at least one of: oxide, nitride or oxynitride of (i) aluminium and/or of (ii) an additive of the aluminium nitride substrate.

In accordance with another aspect of the present invention, there is provided a method of modifying an aluminium nitride substrate, comprising the steps of producing a high density energy means score line in at least one portion of an aluminium nitride substrate, thereby generating metallic aluminium in the vicinity of the score line; heating the scored substrate at a temperature between about 1000°C and about 1800°C; and thereafter metallising the substrate that has been subjected to the heating step.

According to yet another aspect of the invention, there is provided a semiconductor device comprising an insulating substrate and a semiconductor circuit mounted thereon, wherein the substrate comprises an aluminium nitride substrate as defined above.

In order that the invention may be illustrated and readily carried into effect, non-limiting embodiments thereof will now be described by way of example only and with reference to the accompanying drawings in which:
Fig. 1 is an electron photomicrograph showing a sectional view of an aluminium nitride substrate after laser score line formation,
Fig. 2 is an electron photomicrograph showing a sectional view of an aluminium nitride substrate after heating the laser score line formation in the aluminium nitride at 1600°C,
Fig. 3 is an electron photomicrograph showing a magnified sectional view of Fig. 1,
Fig. 4 is an electron photomicrograph showing a magnified sectional view of Fig. 2,
Fig. 5 is a graph taken with an EPMA (Electron Probe Micro Analyser), showing intensity along the vertical axis and the AL-Kβ spectrum along the horizontal axis,
Fig. 6a is a perspective view of an aluminium nitride substrate,
Fig. 6b is a perspective view showing an arrangement in which a score line is formed as a groove on the aluminium nitride substrate, and
Fig. 6c is a perspective view showing the metallised pattern arranged on the divided aluminium nitride substrate.

This invention is directed to an aluminium nitride substrate wherein a re-solidified layer that is formed at the high density energy means worked surface of the aluminium nitride substrate is constituted by one or more types of material from the following: oxides, nitrides and oxynitrides of aluminium and of additives of said aluminium nitride substrate. The additive or each additive, if more than one is present, can be a metal element, such as a group 2 metal and/or a group 3 metal other than aluminium, of the periodic table. If an additive is present it preferably comprises yttrium (Y) and/or calcium (Ca) but more preferably yttrium can be used alone so the aluminium nitride substrate can also comprise yttrium oxide, nitride or oxynitride. It may be preferable to include yttrium oxide within the substrate.

The method of the invention is characterised in that a subsequent heat treatment step at about 1000°C to 1800°C is conducted prior to a step of metallising.

Although aluminium nitride substrates according to this invention include substrates wherein high density energy means is used to form a score line, a through hole formation step and/or a severing step, the following description is mainly concerned with the formation of score lines. As described above, a metallic Al component is formed in the vicinity of the scoring carried out prior to shaping the aluminium nitride substrate to required dimensions. However, this metallic constituent can be nullified, and a re-solidified layer constituted by one or more materials as defined previously can be obtained, by performing a subsequent heat treatment step at about 1000°C to about 1800°C. In this case, an atmosphere of air or nitrogen is preferred.

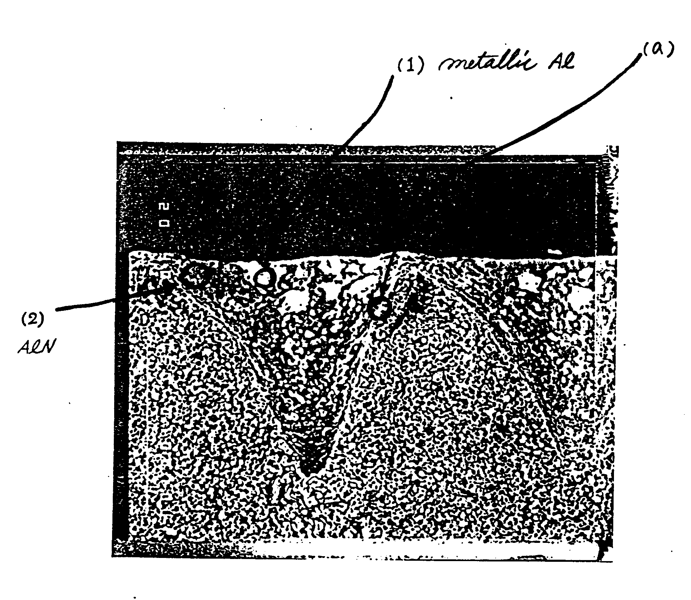

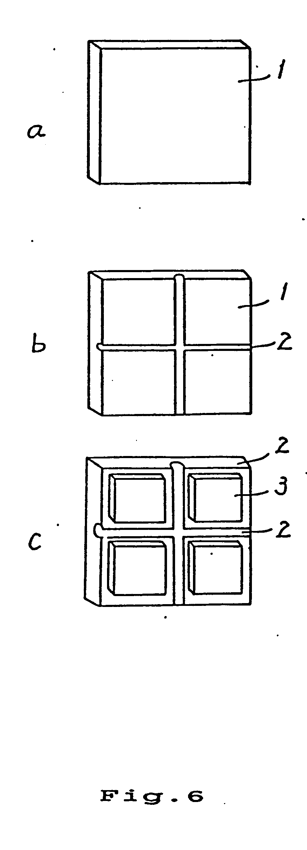

Fig. 1 shows a photograph, obtained using an electron microscope at 400X magnification, of the cross-section after carrying out the step of forming score lines by laser-derived means, as described above. The cross-section of the grooves or holes made with the laser is roughly of inverted triangular shape, and they have a depth of just less than one third the thickness of the aluminium nitride substrate. As shown in Fig. 6b, this photograph was taken along the break position along the score line 2 (consecutive holes), formed in an aluminium nitride substrate 1. There are several shining portions (see part (1) in Fig. 1) on the surface of the holes, which are composed of metallic aluminium. In this case, a "YAG" laser was used at its peak power (10kW).

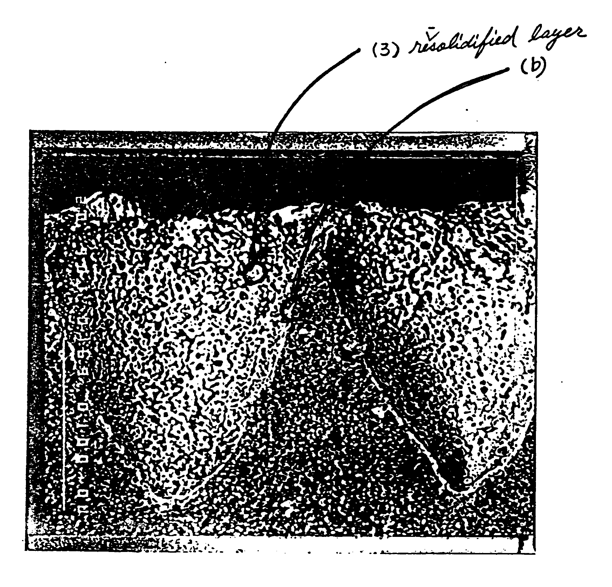

Fig. 2 shows a photograph, obtained using an electron microscope at 400X magnification, of the cross-section of an aluminium nitride substrate according to this invention after heating the laser score line formation in the aluminium nitride at about 1600°C. As in Fig. 2, metallic Al disappeared on the surfaces of the holes. Although there are some shining portions on the surfaces of the holes, these portions are parts of re-solidified layer (see part (3) in Fig. 2). Also, grain boundaries are clearly formed, and it is evident they have a different structure from that of the surrounding aluminium nitride substrate.

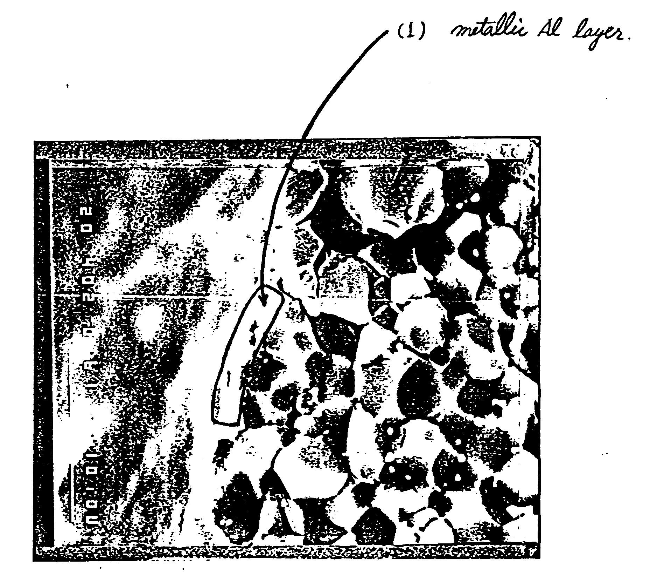

Fig. 3 is an electron photomicrograph taken with a magnification of 4000X, showing a sectional view of an aluminium nitride substrate after laser score line formation in the aluminium nitride. This view is a magnification of part (a) in Fig. 1. From Fig. 3 it can be seen that the metallic component Al (part (1) in Fig. 3) is present, shining on the surface of the hole.

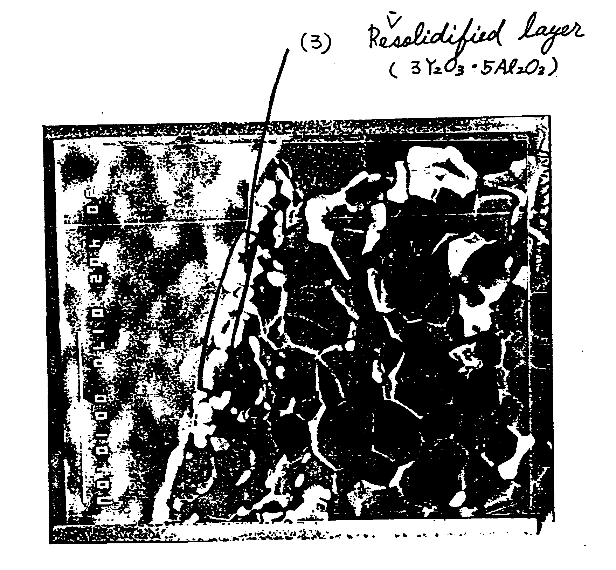

Fig. 4 is an electron photomicrograph taken with a magnification of 4000X, showing a sectional view of an aluminium nitride substrate after heating the laser score line formation in the aluminium nitride at about 1600°C. This view is a magnification of part (b) in Fig. 2. As seen in Fig. 4, a granular re-solidified layer grows adjacent to the aluminium nitride structure of the bulk of the substrate. Its thickness is about 2 to 3 µm.

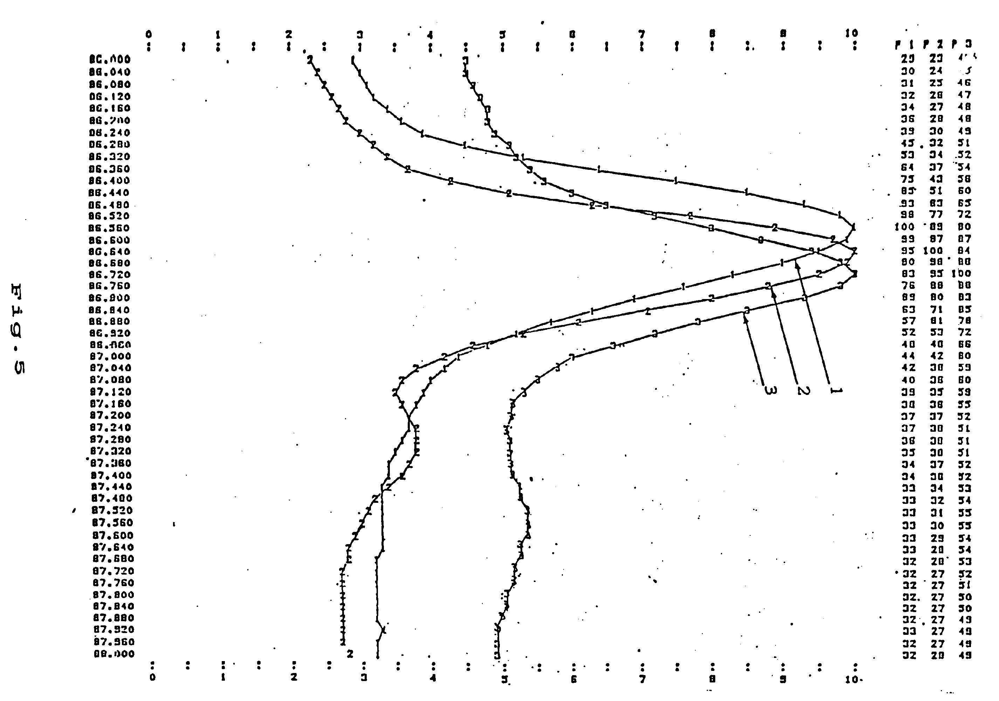

Fig. 5 is a graph taken with an EPMA (Electron Probe Micro Analyser), showing intensity along the vertical axis and the Al-Kβ spectrum along the horizontal axis. Curve 1 is the result of inspecting a shining portion on the surface of the hole in Fig. 1 (the Part (1) in Fig. 1). Curve 2 is the result of inspecting a substrate of the aluminium nitride in Fig. 1 (the part (2) in Fig. 1). Curve 3 is the result of inspecting a shining portion on the surface of the hole in Fig. 2 (the part (3) in Fig. 2).

Curve 1 has a peak of 86.56. This peak represents metallic aluminium. Curve 2 has a peak of 86.64 and a swelling portion of about 87.28. This curve represents aluminium nitride. Curve 3 has a peak of 86.72 and a swelling portion of about 87.56. This curve represents oxides of aluminium and yttrium (e.g. 3Y₂O₃.5Al₂O₃). The yttrium content appearing in curve 3 is an additive of the aluminium nitride. That is, when a heat load is applied to a metallic layer formed at the score line, the metallic component is "nullified" by conversion into an insulating component.

Thus, it is clear that the re-solidified layer formed at the laser-worked surface of the aluminium nitride substrate of this invention may consist of oxides and nitrides of (i) Al and of (ii) additives of the aluminium nitride substrate. Although not indicated in these experimental results, depending on the type of additive of the aluminium nitride substrate, its amount and the laser working conditions, oxynitrides may also be formed.

Owing to the formation at the laser-worked surface of an insulating re-solidified layer having the above-described special composition an aluminium nitride substrate having desired withstand-voltage characteristics can be obtained.

An embodiment of this invention is also now described with reference to Fig. 6a, b and c. Specifically, as shown in Fig. 6a, an aluminium nitride substrate 1 is prepared having the following dimensions: thickness 0.635 mm X 2 inches square, with thermal conductivity 130 W/mk. As shown in Fig. 6b, the front face is then worked to produce 1 inch squares using a laser. After this, it is held for 1 hour in a nitrogen atmosphere maintained at 1600°C, and the substrate is transferred to the subsequent patterning stage. In this patterning step, a metallised pattern 3 is arranged within the one inch squares defined by the score line 2 by, for example, screen printing a vehicle made of Mo, W, and a group 4A element (Ti, Zr and Hf) and/or compounds thereof such as TiO. Next, metallised pattern 3 is completed, as shown in Fig. 6c, by maintaining the substrate in a mixed atmosphere of nitrogen maintained at 1700°C. Next, metallised pattern 3 is covered with a Ni layer (not shown) of thickness 4 µm, by electroless-plating. After this, the substrate is severed along the score lines into 4 subdivided substrates. The subdivided substrates are subjected to withstand-voltage testing. As a result, the substrate exhibits an excellent withstand-voltage.

## Claims

1. An aluminium nitride substrate having a high density energy means generated score line in at least one portion thereof, said substrate having a re-solidified layer in the vicinity of said score line comprised of at least one of: oxide, nitride or oxynitride of (i) aluminium and/or of (ii) an additive of the aluminium nitride substrate.

2. A substrate as claimed in claim 1, wherein the score line is formed of holes, bores, and/or a groove, or a series of one or more thereof.

3. An aluminium nitride substrate according to claim 1 or 2, wherein said high density energy means is laser-derived.

4. A substrate according to any preceding claim, wherein said re-solidified layer comprises oxide, nitride and/or oxynitride of aluminium.

5. A substrate according to any preceding claim, wherein said substrate contains at least one additive comprising one or more metals other than aluminium, and said re-solidified layer comprises oxide, nitride and/or oxynitride of said additive.

6. A substrate according to any preceding claim, wherein said additive comprises yttrium and/or calcium.

7. A substrate according to any preceding claim, which is substantially free of metallic aluminium in the vicinity of said score line.

8. A substrate according to any preceding claim severed along said score line into subdivided substrates.

9. A method of modifying an aluminium nitride substrate comprising the steps of:
producing a high density energy means score line in at least one portion of an aluminium nitride substrate, thereby generating metallic aluminium in the vicinity of the score line;
heating the scored substrate at a temperature between about 1000°C and about 1800°C; and
thereafter metallising the substrate that has been subjected to said heating step.

10. A method according to claim 9, wherein said high density energy means is laser-derived.

11. A method according to claim 9 or 10, wherein said heating step is carried out for a period of time sufficient to convert substantially all of the metallic aluminium to a non-metallic form.

12. A method according to any one of claims 9 to 11, further comprising the step of sub-dividing the scored substrate into multiple substrates along the score line.

13. A method according to any one of claims 9 to 12, wherein said heating step is carried out in an atmosphere of air or nitrogen.

14. A method according to any one of claims 11 to 13, wherein said time period is about 1 hour.

15. A semiconductor device, comprising an insulating substrate and a semiconductor circuit mounted on said substrate, wherein said substrate comprises an aluminium nitride substrate as defined in any one of claims 1 to 8.

16. A device as claimed in claim 15 wherein said substrate has been modified by a method as claimed in any one of claims 9 to 14.

## Patentansprüche

1. Aluminiumnitridsubstrat mit einer durch Mittel mit Energie hoher Dichte erzeugten Kerblinie in mindestens einem Bereich desselben, wobei das Substrat in der Nähe der Kerblinie eine wiederverfestigte Schicht aufweist, die mindestens ein Oxid, Nitrid oder Oxynitrid von (i) Aluminium und/oder (ii) einem Additiv des Aluminiumnitridsubstrats umfaßt.

2. Substrat nach Anspruch 1, bei dem die Kerblinie aus Löchern, Bohrungen und/oder einer furche oder einer Reihe von einem oder mehreren derselben gebildet wird.

3. Aluminiumnitridsubstrat nach Anspruch 1 oder 2, bei dem sich die Mittel mit Energie hoher Dichte von Lasern ableiten.

4. Substrat nach einem der vorhergehenden Ansprüche, bei dem die wiederverfestigte Schicht ein Oxid, Nitrid und/oder Oxynitrid von Aluminium umfaßt.

5. Substrat nach einem der vorhergehenden Ansprüche, bei dem das Substrat mindestens ein Additiv enthält, das ein oder mehrere von Aluminium verschiedene Metalle umfaßt, und die wiederverfestigte Schicht Oxid, Nitrid und/oder Oxynitrid des Additivs umfaßt.

6. Substrat nach einem der vorhergehenden Ansprüche, bei dem das Additiv Yttrium und/oder Calcium umfaßt.

7. Substrat nach einem der vorhergehenden Ansprüche, das in der Nähe der Kerblinie im wesentlichen frei von metallischem Aluminium ist.

8. Substrat nach einem der vorhergehenden Ansprüche, das entlang der Kerblinie in unterteilte Substrate getrennt ist.

9. Verfahren zur Modifizierung eines Aluminiumnitridsubstrats, bei dem:
in mindestens einem Bereich eines Aluminiumnitridsubstrats mit Mitteln mit Energie hoher Dichte eine Kerblinie hergestellt wird, wodurch in der Nähe der Kerblinie metallisches Aluminium erzeugt wird,
das mit einer Kerblinie versehene Substrat auf eine Temperatur zwischen etwa 1000°C und etwa 1800°C erhitzt wird und
das Substrat, das erhitzt worden ist, anschließend metallisiert wird.

10. Verfahren nach Anspruch 9, bei dem sich die Mittel mit Energie hoher Dichte von Lasern ableiten.

11. Verfahren nach Anspruch 9 oder 10, bei dem das Erhitzen über einen Zeitraum durchgeführt wird, der ausreicht, um im wesentlichen alles metallische Aluminium in eine nicht-metallische form umzuwandeln.

12. Verfahren nach einem der Ansprüche 9 bis 11, bei dem das mit einer Kerblinie versehene Substrat entlang der Kerblinie in viele Substrate unterteilt wird.

13. Verfahren nach einem der Ansprüche 9 bis 12, bei dem das Erhitzen in einer Luft- oder Stickstoffatmosphäre durchgeführt wird.

14. Verfahren nach einem der Ansprüche 11 bis 13, bei dem der Zeitraum etwa 1 Stunde beträgt.

15. Halbleitervorrichtung, die ein isolierendes Substrat und eine auf dem Substrat angebrachte Halbleiterschaltung umfaßt, wobei das Substrat ein gemäß einem der Ansprüche 1 bis 8 definiertes Aluminiumnitridsubstrat umfaßt.

16. Vorrichtung nach Anspruch 15, bei der das Substrat nach einem Verfahren gemäß einem der Ansprüche 9 bis 14 modifiziert worden ist.

## Revendications

1. Substrat en nitrure d'aluminium présentant dans l'une de ses parties, au moins, une ligne de rayure produite par des moyens à haute densité d'énergie, ledit substrat comportant, au voisinage de ladite ligne de rayure, une couche resolidifiée comprenant l'une, au moins, des substances suivantes : un nitrure ou oxynitrure de (1) aluminium et/ou (II) un additif du substrat de nitrure d'aluminium.

2. Substrat tel que spécifié sous 1, caractérisé en ce que ladite ligne de rayure est formée de trous, d'ouvertures et/ou d'une rainure, ou d'une série d'un ou de plusieurs de ces derniers.

3. Substrat de nitrure d'aluminium selon la revendication 1 ou 2, caractérisé en ce que la source d'énergie de haute densité est celle d'un laser.

4. Substrat, selon l'une quelconque des revendications précédentes, caractérisé en ce que la couche resolidifiée se compose d'oxyde, de nitrure et/ou d'oxynitrure d'aluminium.

5. Substrat selon l'une quelconque des revendications précédentes, caractérisé en ce que ledit substrat contient au moins un additif contenant un ou plusieurs métaux autres que l'aluminium, et en ce que la couche resolidifiée comprend de l'oxyde, du nitrure et/ou de l'oxynitrure dudit additif.

6. Substrat selon l'une quelconque des revendications précédentes, caractérisé en ce que ledit additif comprend de l'yttrium et/ou du calcium.

7. Substrat selon l'une quelonque des revendications précédentes, caractérisé en ce qu'il est pratiquement dépourvu d'aluminium métallique au voisinage de ladite ligne de rayure.

8. Substrat selon l'une quelconque des revendications précédentes, caractérisé en ce qu'il est divisé en un certain nombre de substrats séparés le long de ladite ligne de rayure.

9. Procédé pour modifier un substrat de nitrure d'aluminium qui consiste :
à produire une ligne de rayure avec des moyens à haute énergie, dans une partie, au moins, d'un substrat de nitrure d'aluminium, en produisant ainsi de l'aluminium métallique au voisinage de ladite ligne de rayure;
à chauffer ledit substrat à une température comprise entre environ 1000°C et environ 1800°C; et
à métalliser ensuite le substrat qui a été soumis à ladite étape de chauffage.

10. Procédé selon la revendication 9, caractérisé en ce que l'énergie à haute densité utilisée provient d'un laser.

11. Procédé selon la revendication 9 ou 10, caractérisé en ce qu'on exécute ladite étape de chauffage pendant une période de temps suffisant pour convertir pratiquement tout l'aluminium métallique dans un état non-métallique.

12. Procédé selon l'une quelconque des revendications 9 à 11, caractérisé en ce qu'il comprend encore une étape consistant à subdiviser le substrat rayé en une multiplicité de substrats le long de la ligne de rayure.

13. Procédé selon l'une quelconque des revendications 9 à 12, caractérisé en ce qu'on exécute ladite étape de chauffage dans une atmosphère d'air ou d'azote.

14. Procédé selon l'une quelconque des revendications 11 à 13, caractérisé en ce que ladite période de temps est d'environ une heure.

15. Dispositif semi-conducteur qui comprend un substrat isolant et un circuit semi-conducteur monté sur ledit substrat, ledit substrat étant un substrat à base de sitrure d'aluminium tel que spécifié dans l'une quelconque des revendications 1 à 8.

16. Dispositif selon la revendication 15, caractériré en ce que ledit substrat a été modifié par le procédé spécifié dans l'une quelconque des revendications 9 à 14.
